# EUROPÄISCHE PATENTSCHRIFT

(11) **EP 0 868 784 B1**
(45) Veröffentlichungstag und Bekanntmachung des Hinweises auf die Patenterteilung: **04.08.1999**
(21) Anmeldenummer: 96945340.6
(22) Anmeldetag: 26.09.1996
(51) Int. Cl.: H03L 7/189, H03J 1/00

(54) **MISCHOSZILLATOR MIT EINEM PHASENGERASTETEN REGELKREIS FÜR EINEN RUNDFUNKEMPFÄNGER**
COMBINING OSCILLATOR WITH A PHASE-INDEXED CONTROL CIRCUIT FOR A RADIO RECEIVER
OSCILLATEUR COMBINATEUR AVEC CIRCUIT REGULATEUR A VERROUILLAGE DE PHASE POUR RECEPTEUR RADIO

(30) Priorität: 23.12.1995 DE 19548539
(43) Veröffentlichungstag der Anmeldung: 07.10.1998
(73) Patentinhaber: ROBERT BOSCH GMBH, 70442 Stuttgart (DE)
(72) Erfinder: NYENHUIS, Detlev, D-31079 Sibbesse (DE)
(86) Internationale Anmeldenummer: DE9601818
(87) Internationale Veröffentlichungsnummer: WO9723957

(56) Entgegenhaltungen:
- EP-A- 0 406 469
- EP-A- 0 484 246
- US-A- 4 442 412
- US-A- 5 023 572
- US-A- 5 207 491
- ELECTRONICS & COMMUNICATIONS IN JAPAN, PART II - ELECTRONICS, Bd. 77, Nr. 7, 1.Juli 1994, Seiten 1-9, XP000493750 YOSHIAKI TARUSAWA ET AL: "TWIN-COUNTER DIGITAL-LOOP PRESET FREQUENCY SYNTHESIZER (TC-DLPS)"

## Beschreibung

### Stand der Technik

In vielen Rundfunkempfängern wird als Mischoszillator eine Oszillatorschaltung mit einem phasengerasteten Regelkreis (PLL) eingesetzt, der ein analoges Schleifenfilter umfaßt. Veranlaßt der Hörer eine Änderung der Empfangsfrequenz, so müssen dabei unter anderem die Kondensatoren in dem analogen Schleifenfilter der PLL umgeladen werden. Die erforderliche Umladezeit lassen die Neuabstimmung eines Rundfunkempfängers insbesondere bei testweisem Einschalten von alternativen Frequenzen träge erscheinen.

Eine Mischoszillatorschaltung mit verkürzter Testzeit ist in der älteren Patentanmeldung P 195 10 220.7 beschrieben.

Aus der EP - A - 0 406 469 ist eine digitale Steuerschaltung für Abstimmsysteme mit einer Einrichtung zur Erzeugung einer Tuner-Abstimmspannung bekannt. Bei der beschriebenen Steuerschaltung wird das Ausgangssignal eines Phasendiskriminators einem digitalen Integrator als Schleifenfilter der Phasenregelschleife zugeführt, wobei der in dem Integrator gespeicherte Wert nach einer Digital-/Analog-Wandlung die Abstimmspannung bildet. Zur schnellen Umschaltung der Tuner-Abstimmspannung ist dabei der Integrator auf einen der gewünschten Tuner-Abstimmspannung entsprechenden Wert vorsetzbar.

### Vorteile der Erfindung

Der erfindungsgemäße Mischoszillator mit den Merkmalen des Hauptanspruchs ermöglicht demgegenüber durch Verwendung zweier wahlweise in den Regelkreis einschaltbarer Integratoren eine besonders schnelle Umschaltung zwischen zwei vorgegebenen Misch- und damit Empfangsfrequenzen des Rundfunkempfängers. Dies ist insbesondere bei sogenannten Alternativfrequenztests von Vorteil, bei denen eine schnelle Umschaltung von einer empfangenen auf eine alternative Frequenz und von dieser wieder zurück auf die ursprüngliche Empfangsfrequenz erfolgen soll.

Bei größeren Frequenzsprüngen unterstützen die Merkmale der Ansprüche 2 und 3 eine kurze Umschaltzeit. Der Anspruch 4 kennzeichnet eine Ausführungsform der Erfindung für Phasendiskriminatoren mit digital niedrig aufgelösten Ausgangsgrößen. In den Ansprüchen 5 und 6 sind unterschiedliche Mittel zur Kompensation der Nichtlinearität der Oszillatorkennlinie gekennzeichnet.

Die Ansprüche 7 und 8 kennzeichnen eine Ausführungsform der Erfindung, in der ein Gleichspannungsanteil in dem MPX-Signal zur Empfängerabstimmung mit genutzt wird.

### Zeichnung

Anhand der in der Zeichnung dargestellten Blockschaltbilder wird die Erfindung näher erläutert. Es zeigen
- Fig. 1: das Blockschaltbild eines Rundfunkempfängers mit einem Mischoszillator, der von einem phasengerasteten Regelkreis gesteuert wird, welcher ein digitales Schleifenfilter umfaßt,
- Fig. 2: ein Blockschaltbild eines Rundfunkempfängers mit zwei umschaltbaren digitalen Schleifenfiltern in dem Regelkreis des Mischoszillators,
- Fig. 3: ein Blockschaltbild eines Regelkreises mit einer zusätzlichen Schaltung zur iterativen Annäherung der Ist-Frequenz an die Soll-Frequenz,
- Fig. 4: das Blockschaltbild eines Regelkreises mit einer zusätzlichen Schaltung zur Polynom-Berechnung der inversen VCO-Kennlinie,
- Fig. 5: ein Blockschaltbild eines Regelkreises, in dem ein Gleichspannungsanteil im MPX-Signal ausgewertet wird.

### Beschreibung

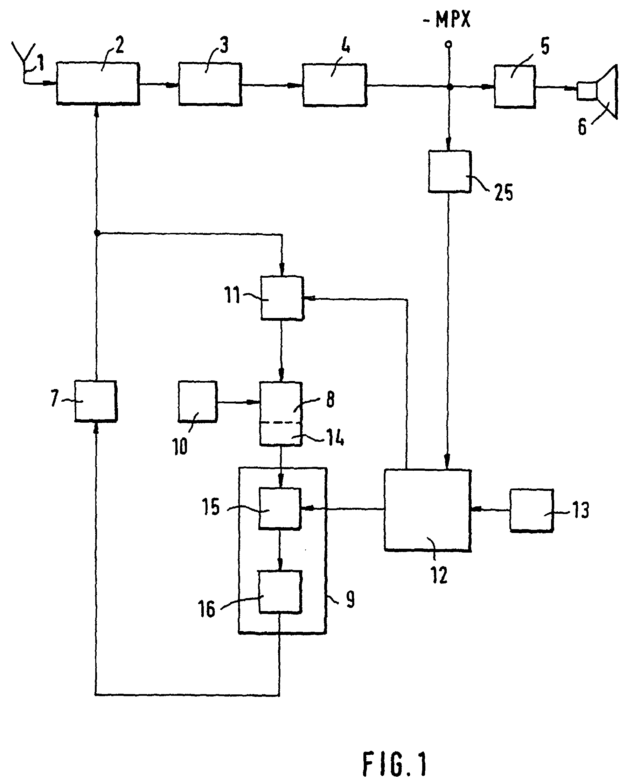

In Fig. 1 sind neben den wesentlichen Schaltblöcken eines Rundfunkempfängers die Bausteine eines Mischoszillators mit einem phasengerasteten Regelkreis im Detail dargestellt.

Über die Antenne 1 wird ein Frequenzbereich empfangen, in dem die Trägerfrequenz des gewünschten Programms zu finden ist. Diese Trägerfrequenz wird mit Hilfe der Mischstufe 2 aus dem Empfangsspektrum ausgefiltert und in die Zwischenfrequenzlage umgesetzt. An die Mischstufe 2 ist eine ZF-Stufe angeschlossen, deren Ausgang mit einem FM-Demodulator 4 verbunden ist, an welchem ein die Trägerfrequenz modulierendes MPX-Signal abgreifbar ist.

In dem MPX-Signal ist - wie man weiß - bis zur völligen Abstimmung des Rundfunkempfängers auf die Trägerfrequenz ein Gleichspannungsanteil vorhanden. Doch ist dieser Gleichspannungsanteil so gering, daß er in analogen Abstimmschaltungen wegen der notwendigen Bauteiletoleranzen nicht auswertbar ist.

Aus dem MPX-Signal wird in einer NF-Stufe 5 das Tonsignal zurückgewonnen und über einen Lautsprecher 6 zu Gehör gebracht. Daneben enthält das MPX-Signal beim Empfang von RDS-Sendern Radiodatensignale, die einem 57-kHz-Hilfsträger aufmoduliert sind und in einem RDS-Decoder 25 ausgewertet werden.

Der Rundfunkempfänger wird über den Mischoszillator 7 auf die Trägerfrequenz des gewünschten Programms abgestimmt. Dazu wird neben dem Signal der Antenne 1 die Frequenz des Mischoszillators 7 in die Mischstufe 2 eingespeist. Die Mischfrequenz liegt im allgemeinen um den Betrag der Zwischenfrequenz (ZF) über der gesuchten Trägerfrequenz. Der Mischoszillator wird von einem spannungsgesteuerten Oszillator, auch kurz VCO genannt, gebildet, der beispielsweise aus der Reihenschaltung eines Schwingquarzes mit einer Varicap-Diode besteht, deren Spannungsversorgung steuerbar ist.

Die phasengerastete Regelschleife für den VCO 7 umfaßt einen Phasendiskriminator 8, ein Schleifenfilter 9 und einen Referenzoszillator 10 sowie einen steuerbaren Teiler 11, in dem mit dem Ausgang des VCO verbundenen Eingangs des Phasendiskriminators 8.

Mit dem in dem Teiler 11 eingestellten Teilungsverhältnisses wird der Sollwert der Mischfrequenz vorgegeben; denn nur, wenn deren Ist-Wert mit dem Soll-Wert - nämlich der Trägerfrequenz des gewünschten Programms - übereinstimmt, entspricht die heruntergeteilte Mischfrequenz der Referenzfrequenz des Referenzoszillators 10. Auf die Einstellung von unterschiedlichen Größen dieser Referenzfrequenz in den verschiedenen Empfangsbändern (UKW, KW, MW, LW) und deren Einstellung, braucht hier nicht näher eingegangen zu werden.

Die den einzelnen Mischfrequenzen zugeordneten Teilerverhältnisse sind in einem Speicher eines Mikroprozessors 12 abgelegt, der den Teiler 11 steuert. Bei dem Empfang von Trägerfrequenzen im UKW-Band liegen die Teilerverhältnisse im allgemeinen in der Größenordnung von mehreren Tausend.

In dem Phasendiskriminator 8 wird die heruntergeteilte Mischfrequenz mit der Frequenz des Referenzoszillators 10 nach Frequenz- und Phasenlage verglichen. Bei dem Vergleich entsteht am Ausgang des Phasendiskriminators 8 eine Steuerspannung, die den VCO 7 nachregelt bis Gleichheit zwischen der Frequenz und der Phase der Schwingungen beider Oszillatoren 7 und 10 hergestellt ist.

Das dem Phasendiskriminator 8 nachgeschaltete Schleifenfilter 9 unterdrückt höherfrequente Spektralanteile in der Steuerspannung.

Soll der Empfänger auf den Empfang eines bestimmten neuen Programms eingestellt werden, so kann mit einer Stationstaste 13 in dem Mikroprozessor 12 der Ablauf eines zugeordneten Programms ausgelöst werden. Dieses Steuerprogramm bewirkt unter anderem die Änderung des Teilerverhältnisses in dem Teiler 11. Auf eine Neueinstellung des Teilers 11 reagiert der Phasendiskriminator 8 mit einer Änderung seines digitalen bzw. in einem A/D-Wandler 14 digitalisierten Ausgangssignals. Dessen neuer Zahlenwert wird in dem digitalen Schleifenfilter 9 in einem Integrator 15 gespeichert. Der neue Integratorinhalt wird in einem D/A-Wandler 16 in eine geänderte Steuerspannung für den VCO 7 umgewandelt, der nunmehr eine entsprechend veränderte Mischfrequenz abgibt. Dieser Regelvorgang endet, wenn die Mischfrequenz den für den Empfang des neuen Programms erforderlichen Wert hat.

Der Einstellvorgang erfordert mit dem neuen, aus dem Integrator 15 und dem D/A-Wandler 16 bestehenden digitalen Schleifenfilter 9 in der PLL eine wesentlich kürzere Zeit als bei Verwendung eines analogen Schleifenfilters, weil die hier für jede Neueinstellung der Frequenz erforderliche Umladezeit der Kondensatoren in entsprechenden Netzwerken entfällt. Maßgeblich ist nunmehr die Taktzeit der Digitalschaltung.

Die Einstellzeit des Mischoszillators auf eine vorprogrammierte neue Mischfrequenz läßt sich bei Verwendung eines digitalen Schleifenfilters darüber hinaus verkürzen, wenn das Schleifenfilter 9 über einen Eingang verfügt, in den neben dem Zahlenwert des digitalen Ausgangs des Phasendiskriminators 8 ein weiterer Zahlenwert zusätzlich eingespeist werden kann. Für die Einspeisung dieses zusätzlichen Zahlenwertes ist in Fig. 1 der Integrator beispielsweise mit einem zweiten Eingang versehen, der mit dem Mikroprozessor 12 verbunden ist.

Der zusätzliche Zahlenwert dient folgendem Zweck. Wenn die neu einzustellende Frequenz festliegt, ist nicht nur das im Frequenzteiler 11 einzustellende Teilerverhältnis bekannt, sondern auch die Höhe der erforderlichen Steuerspannung für den VCO. Diese Steuerspannung entsteht in dem neuen Schleifenfilter 9 am Ausgang des D/A-Wandlers 16 und wird von dem Inhalt des vorgeschalteten Integrators 15 bestimmt. Mithin ist mit der erforderlichen Steuerspannung auch der zugeordnete Zahlenwert für den Integrator bekannt.

Zugleich mit der Neueinstellung des Teilerverhältnisses über den Mikroprozessor 12 wird von diesem ein der Höhe der neuen Steuerspannung entsprechender Zahlenwert über den erwähnten Eingang in den Integrator 15 eingespeist. Dadurch wird der VCO 7 schneller auf die neue Mischfrequenz gezogen.

An einem Zahlenbeispiel soll die zusätzliche Einspeisung eines Zahlenwertes in den Integrator 15 verdeutlicht werden. Der Frequenz von 87,5 MHz (+ ZF), welche die Untergrenze des UKW-Bandes darstellt, sei eine Steuerspannung von 1,8 V an dem Eingang des VCO 7 zugeordnet, während die Frequenz von 108 MHz (+ ZF) - die Obergrenze des UKW-Bandes - eine Spannung von 6,3 V erfordert. Wenn der D/A-Wandler 16 im Ausgang des digitalen Schleifenfilters 8 z. B. zehn Bit breit ist, dann wird der erforderliche Spannungsbereich von (6,3 V - 1,8 V) = 4,5 V in 1024 verschiedene Zahlenwerte unterteilt. Jedem Zahlenwert entspricht eine andere Mischfrequenz. Soll die Mischfrequenz z. B. vom oberen Ende des UKW-Bandes zum unteren Ende zurückspringen, dann wird für diesen Sprung vom Mikroprozessor neben der entsprechenden Änderung des Teilerverhältnisses im Teiler 11 auch eine Entladung des Integrators 15 von 1 024 auf 0 herbeigeführt.

Somit läßt sich eine vorprogrammierte automatische Neueinstellung eines Senders mit Hilfe eines aufladbaren digitalen Schleifenfilters in einer bisher nicht erreichten kurzen Zeitdauer bewirken.

Der Phasendiskriminator 8 liefert danach nur noch ein Ausgangssignal, das der Restabweichung zwischen seinen beiden Eingangsschwingungen entspricht. Diese Restabweichung kann durch eine noch vorhandene Phasenablage der momentanen Mischfrequenz von der Soll-Frequenz bestimmt sein. Denn infolge des hohen Teilerverhältnisses entspricht selbst bei richtiger Frequenzlage einer verbleibenden Phasenabweichung in der Mischfrequenz eine Frequenzabweichung der heruntergeteilten Mischfrequenz von der Referenzfrequenz. Auch Temperaturschwankungen können eine Restabweichung bewirken.

Da das digitale Schleifenfilter keine Kondensatoren enthält, kann sich der einmal erreichte Wert für die Steuerspannung des VCO auch nicht infolge von auf Leckströmen beruhenden Kondensatorentladungen merklich verändern. Somit werden auch Nachregelvorgänge bei Einsatz eines digitalen Schleifenfilters vermindert.

Ein digitales Schleifenfilter läßt sich besonders vorteilhaft einsetzen, wenn eine alternative Frequenz zu der eingestellten Empfangs frequenz testweise eingestellt werden soll. Solche alternativen Frequenzen werden bekanntlich mittels des Radiodatensignals in den Empfänger übertragen. Diese Tests sind an sich bekannt.

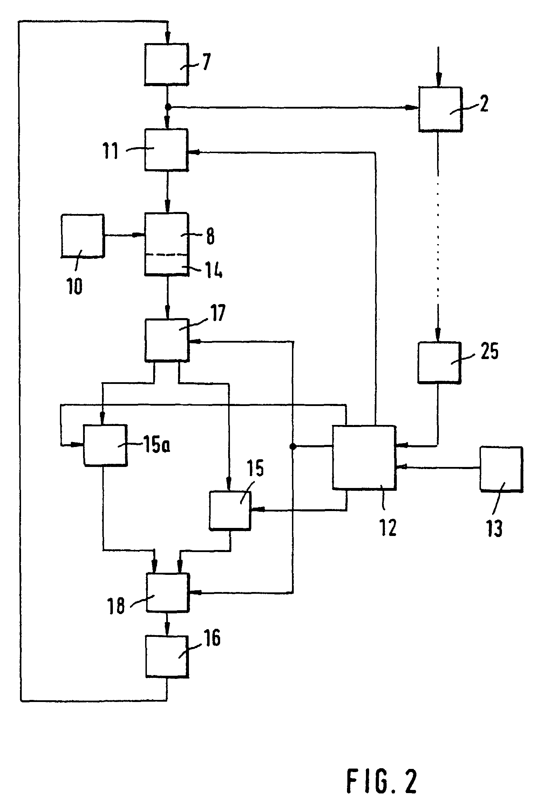

Für einen solchen Test verfügt die phasengerastete Regelschleife, wie in Fig. 2 dargestellt ist, über zwei Integratoren 15 und 15a, die wahlweise über vom Mikroprozessor 12 synchron gesteuerte Umschalter 17 und 18 alternativ in den Schleifenfilterwirkungskreis einschaltbar sind. Vor der Umschaltung wird der zweite Integrator 15a vom Mikroprozessor 12 auf den der alternativen Frequenz entsprechenden Zahlenwert vorgeladen. Bei der Umschaltung selbst wird nur noch das Teilerverhältnis in dem Teiler 11 geändert. Die Ermittlung des erforderlichen Zahlenwertes erfolgt aus den vom RDS-Decoder 25 gelieferten Angaben für die alternative Frequenz des eingestellten Senders und den in dem Mikroprozessor 12 gespeicherten Zahlenwert, welcher der alternativen Frequenz neben dem Teilerverhältnis des Teilers 11 zugeordnet ist.

Ergibt der Test nach der Umschaltung, das der Sender mit der alternativen Frequenz schlechtere Empfangswerte hat als der zuvor eingestellte Sender, dann werden die Umschalter 17 und 18 zurückgeschaltet. Dabei steht in dem ersten Integrator 15 der alte Inhalt wieder zur Verfügung, bei dem der VCO 7 bereits auch phasenrichtig auf die Trägerfrequenz abgestimmt war. Beim Rücksprung entfällt also noch der beim Hinschalten auf die alternative Frequenz erforderliche Zeitbedarf zur Herstellung der richtigen Mischfrequenz.

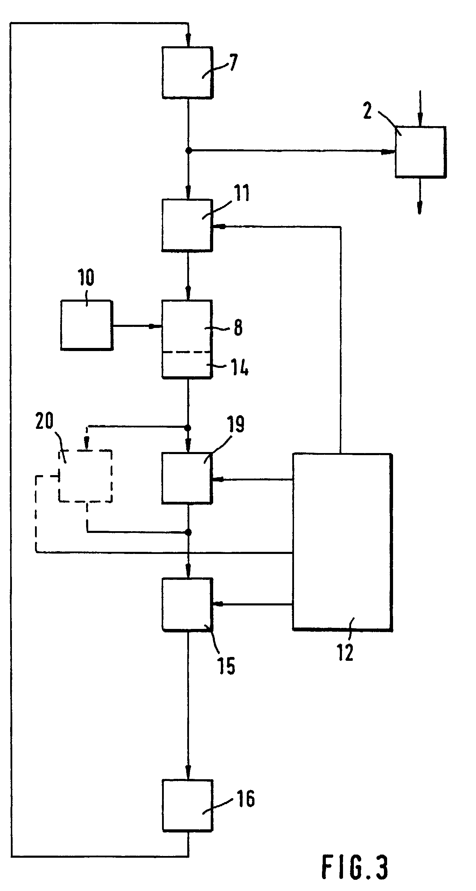

Bei Verwendung von Phasendiskriminatoren mit niedriger digitaler Auflösung des Ausgangssignals, z. B. mit 1-Bit oder 2-Bit-breiten Datenwörtern, kann - wie in Fig. 3 dargestellt ist - eine Schaltung 19 zur iterativen Annäherung der Mischfrequenz an die Soll-Frequenz zwischen dem Ausgang des Phasendiskriminators 8 und dem Eingang des Integrators 15 eingeschleift werden. Diese Schaltung 19 ist so ausgelegt, daß sie nach einer Frequenzänderung zunächst einen größeren Zahlenwert erzeugt und in den Integrator 15 einspeist und danach z. B. ein halb so großen Zahlenwert erzeugt und so gegebenenfalls auch mit einem Vorzeichenwechsel fortschreitend. Diese Zahlenwerte abnehmender Größe werden taktweise in dem Integrator 15 zu dem vorhandenen Integratorinhalt addiert oder von ihm subtrahiert und führen so iterativ über den D/A-Wandler 16 zu der erforderlichen Höhe der Steuerspannung für den VCO 7 für die neue Abstimmung des Empfängers.

Bekanntlich ist die Kennlinie eines VCO 7 nicht linear, d. h. eine Spannungsänderung von 0,25 V hat am oberen Ende des UKW-Bandes eine geringere Frequenzänderung zur Folge als am unteren Bandende. Die Linearisierung der Kennlinie kann mittels einer Schaltung 20 erfolgen, die anstelle der Schaltung 19 in Fig. 3 vor dem Eingang des Integrators 15 angeordnet ist. Die Schaltung 20 variiert die digitalen bzw. digitalisierten Ausgangssignale des Phasendiskriminators 8 entsprechend der momentanen Lage der Mischfrequenz in dem Empfangsbereich. Er vergrößert sie also z. B. am oberen Ende des UKW-Bandes und verkleinert sie am unteren Bandende. Die Steuerung der Schaltung 20 entsprechend der Lage der Mischfrequenz erfolgt z. B. durch den Mikroprozessor 12.

Bei Verwendung einer Schaltung 19 zur iterativen Annäherung der Ist-Frequenz an die Soll-Frequenz ist es zweckmäßig, das Iterationsverfahren mit dem soeben beschriebenen Variationsverfahren zu kombinieren, so daß die Zahlenwerte der einzelnen Iterationsschritte von der Lage der Mischfrequenz abhängen und am unteren Bandende kleiner sind als am oberen Ende des UKW-Bandes.

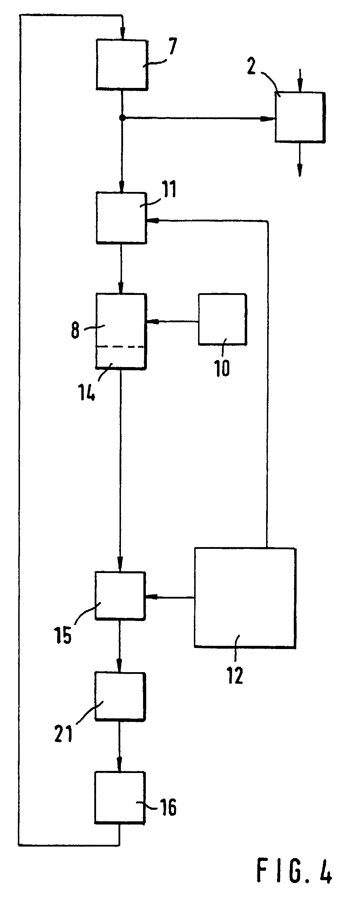

Um in jedem Frequenzbereich mit der gleichen Zahlenwertdifferenz die gleiche Frequenzänderung zu erreichen, ist in dem in Fig. 4 dargestellten Ausführungsbeispiel eine an sich bekannte Schaltung 21 zur Invertierung der Oszillatorkennlinie mittels einer Polynomen-Berechnung zwischen dem Ausgang des Integrators 15 und dem Eingang des D/A-Wandlers 16 eingeschleift. Diese Schaltung stellt eine Alternative zu der in Fig. 3 dargestellten Schaltung 20 dar.

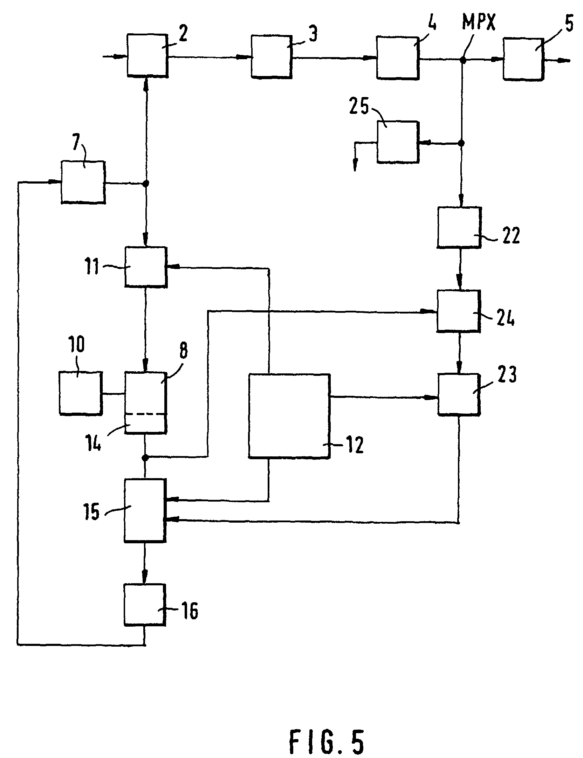

Bei der im ersten Ausführungsbeispiel angesprochenen hohen digitalen Auflösung des Integratorinhalts läßt sich auch eine Tatsache zur Abstimmung des Rundfunkempfängers heranziehen, die bei analogen Schleifenfiltern wegen der erforderlichen Toleranz der Bauelemente bisher nicht genutzt werden konnte. Wie bereits erwähnt, verbleibt bei ungenauer Abstimmung des Mischoszillators in dem am Ausgang des FM-Demodulators 4 abnehmbaren MPX-Signal ein Gleichspannungsanteil. Wenn man diese Spannung - wie in Fig. 5 gezeigt - durch einen Detektor 22 überwacht und in einem Analog/Digital-Wandler 23 in einen Zahlenwert umwandelt, dann kann das Mikroprozessorprogramm mit dessen Wert den Integratorinhalt zusätzlich verändern. Dazu weist das Schleifenfilter 9 einen dritten Steuereingang für den Integrator 15 auf. Zweckmäßigerweise wird dieser Steuereingang durch das Mikroprozessorprogramm über eine Torschaltung 24 nur dann für die Übernahme dieses zusätzlichen Abstimmwertes geöffnet, wenn der Phasendiskriminator 8 die Übereinstimmung der beiden Eingangsfrequenzen nach Frequenz und Phase anzeigt.

## Patentansprüche

1. Mischoszillator für einen Rundfunkempfänger mit einem phasengerasteten Regelkreis (PLL), der einen spannungsgesteuerten Oszillator (7), einen Phasendiskriminator (8), einen Integrator (15) zur Speicherung digitaler oder digitalisierter Ausgangsgrößen des Phasendiskriminators (8) und einen Digital-/Analog-Wandler (16) zur Umwandlung des Integratorinhalts in eine Steuerspannung für den spannungsgesteuerten Oszillator (7) umfaßt, dadurch gekennzeichnet, daß ein zweiter Integrator (15a) zum Speichern eines von dem im Integrator (15) gespeicherten Wert verschiedenen Wertes vorgesehen ist, und daß zum Wechsel zwischen zwei verschiedenen Empfangsfrequenzen wahlweise einer der beiden Integratoren (15, 15a) mittels dazu vorgesehener Mittel (17, 18), vorzugsweise zweier synchron betätigter Umschalter, in den Regelkreis einschaltbar ist.

2. Mischoszillator nach Anspruch 1, dadurch gekennzeichnet, daß ein Mikroprozessor (12) zur Vorgabe eines Sollwertes der vom Oszillator (7) erzeugten Mischfrequenz vorgesehen ist, der zur Frequenzänderung einen dem Sollwert der Mischfrequenz zugeordneten Zahlenwert in den Integrator (15) einspeist.

3. Mischoszillator nach Anspruch 2, gekennzeichnet durch einen ersten Eingang am Integrator (15) für die Zahlenwerte des digitalisierten Ausgangssignals des Phasendiskriminators (8) und einen zweiten Eingang für den der Mischfrequenz zugeordneten Zahlenwert.

4. Mischoszillatorschaltung nach einem der vorhergehenden Ansprüche mit einer digital niedrig aufgelösten Ausgangsgröße des Phasendiskriminators, gekennzeichnet durch eine dem Integrator (15) vorgeschaltete Schaltung (19), die Zahlenwerte abnehmender Größe und gegebenfalls wechselnden Vorzeichens in den Integrator (15) zur iterativen Annäherung der Mischoszillatorfrequenz an den Sollwert einspeist.

5. Mischoszillator nach einem der vorhergehenden Ansprüche, gekennzeichnet durch eine dem Integrator (15) vorgeschaltete Schaltung (20), die die Ausgangsgröße des Phasendiskriminators (8) entsprechend der Frequenzlage des spannungsgesteuerten Mischoszillators (7) zur Kompensation der Nichtliniarität der Oszillatorkennlinie variiert.

6. Mischoszillator nach einem der Ansprüche 1 bis 4, gekennzeichnet durch eine Schaltung (21) zur Polynom-Berechnung der inversen Oszillatorkennlinie zwischen dem Ausgang des Integrators (15) und dem Eingang des Digital-Analog-Wandlers (16).

7. Mischoszillator nach einem der vorhergehenden Ansprüche, gekennzeichnet durch einen Detektor (22) für einen Gleichspannungsanteil in dem MPX-Signal des Rundfunkempfängers, dessen Ausgang gegebenenfalls über einen Analog-Digitalwandler (23) mit einem zugeordneten Steuereingang für den Integrator (15) verbunden ist.

8. Mischoszillatorschaltung nach Anspruch 7, gekennzeichnet durch eine Torschaltung (24) im Ausgang des Detektors (22), die geöffnet ist, wenn der Phasendiskriminator (8) die Übereinstimmung der zu vergleichenden Frequenzen anzeigt.

## Claims

1. Mixing oscillator for a radio receiver having a phase-locked loop (PLL), which comprises a voltage-controlled oscillator (7), a phase discriminator (8), an integrator (15) for the storage of digital or digitized output quantities of the phase discriminator (8) and a digital/analogue converter (16) for converting the integrator content into a control voltage for the voltage-controlled oscillator (7), characterized in that provision is made of a second integrator (15a) for storing a value which is different from the value stored in the integrator (15) and in that, in order to change over between two different reception frequencies, either one of the two integrators (15, 15a) can be optionally connected into the phase-locked loop by means (17, 18) provided for this purpose, preferably by two synchronously actuated changeover switches.

2. Mixing oscillator according to Claim 1, characterized in that provision is made of a microprocessor (12) for specifying a desired value of the mixed frequency generated by the oscillator (7), which microprocessor, in order to change the frequency, feeds a numerical value assigned to the desired value of the mixed frequency into the integrator (15).

3. Mixing oscillator according to Claim 2, characterized by a first input at the integrator (15) for the numeric values of the digitized output signal of the phase discriminator (8) and a second input for the numerical value assigned to the mixed frequency.

4. Mixing oscillator circuit according to one of the preceding claims with a digitally low-resolution output quantity of the phase discriminator, characterized by a circuit (19), which is connected upstream of the integrator (15) and feeds numerical values of decreasing magnitude and, if appropriate, changing sign into the integrator (15) for the purpose of iterative approximation of the mixing oscillator frequency to the desired value.

5. Mixing oscillator according to one of the preceding claims, characterized by a circuit (20), which is connected upstream of the integrator (15) and varies the output quantity of the phase discriminator (8) in accordance with the frequency of the voltage-controlled mixing oscillator (7) in order to compensate for the non-linearity of the oscillator characteristic.

6. Mixing oscillator according to one of Claims 1 to 4, characterized by a circuit (21) for polynomial calculation of the inverse oscillator characteristic between the output of the integrator (15) and the input of the digital-analogue converter (16).

7. Mixing oscillator according to one of the preceding claims, characterized by a detector (22) for a DC voltage component in the MPX signal of the radio receiver, whose output is connected to an assigned control input for the integrator (15) via an analogue-digital converter (23), if appropriate.

8. Mixing oscillator circuit according to Claim 7, characterized by a gate circuit (24) in the output of the detector (22), which gate circuit is open when the phase discriminator (8) indicates correspondence between the frequencies to be compared.

## Revendications

1. Oscillateur mélangeur pour un récepteur radio comprenant un circuit de régulation à verrouillage de phase (PLL) avec un oscillateur commandé en tension (7), un discriminateur de phase (8), un intégrateur (15) pour mémoriser des grandeurs de sortie numériques du discriminateur de phase (8), ainsi qu'un convertisseur numérique/analogique (16) pour convertir le contenu de l'intégrateur en une tension de commande de l'oscillateur commandé en tension (7),
caractérisé par :
un second intégrateur (15a) pour mémoriser une valeur différente de la valeur mémorisée dans l'intégrateur (15) et, pour changer entre deux fréquences de réception différentes, l'un des deux intégrateurs (15, 15a) est branché sélectivement dans le circuit de régulation par des moyens (17, 18) prévus à cet effet, notamment deux commutateurs à commande synchronisée.

2. Oscillateur mélangeur selon la revendication 1,
caractérisé par
un microprocesseur (12) qui prédétermine une valeur de consigne de la fréquence mélangée générée par l'oscillateur 7, pour fournir à l'intégrateur (15) une valeur numérique associée à la valeur de consigne de la fréquence de mélange, pour modifier la fréquence.

3. Oscillateur mélangeur selon la revendication 2,
caractérisé par
une première entrée sur l'intégrateur (15) pour les valeurs numériques du signal de sortie numérisé du discriminateur de phase (8), et une seconde entrée pour la valeur numérique associée à la fréquence mélangée.

4. Oscillateur mélangeur selon l'une quelconque des revendications précédentes, avec une grandeur de sortie numérique à faible résolution du discriminateur de phase,
caractérisé par
un circuit (19) en amont de l'intégrateur (15) qui adapte des valeurs de grandeur décroissante et le cas échéant avec un signe algébrique changeant dans l'intégrateur (15) pour une approximation itérative de la fréquence de l'oscillateur mélangeant à la valeur de consigne.

5. Oscillateur mélangeur selon l'une des revendications précédentes,
caractérisé par
un circuit (20) en amont de l'intégrateur (15) qui modifie la grandeur de sortie du discriminateur de phase (8) en fonction de la position de fréquence de l'oscillateur mélangeur (7) commandé en tension, pour compenser la non linéarité de la caractéristique de l'oscillateur.

6. Oscillateur mélangeur selon l'une des revendications 1 à 4,
caractérisé par
un circuit (21) de calcul polynomial de la courbe caractéristique inverse de l'oscillateur, ce circuit étant branché entre la sortie de l'intégrateur (15) et l'entrée du convertisseur numérique/analogique (16).

7. Oscillateur mélangeur selon l'une des revendications précédentes,
caractérisé par
un détecteur (22) pour une composante de tension continue dans le signal MPX du récepteur radio, dont la sortie est également reliée par un convertisseur analogique/numérique (23) à une entrée de commande associée de l'intégrateur (15).

8. Oscillateur mélangeur selon la revendication 7,
caractérisé par
un circuit de porte (24) à la sortie du détecteur (22), cette porte étant ouverte lorsque le discriminateur de phase (8) indique la concordance des fréquences à comparer.
